# EUROPEAN PATENT SPECIFICATION

(11) **EP 3 306 440 B1**
(45) Date of publication and mention of the grant of the patent: **23.01.2019**
(21) Application number: 17191359.3
(22) Date of filing: 15.09.2017
(51) Int. Cl.: G06F 1/18

(54) **INTERFACE CARD FIXING DEVICE AND MAIN BOARD MODULE**
SCHNITTSTELLENKARTENBEFESTIGUNGSVORRICHTUNG UND HAUPTPLATINENMODUL
DISPOSITIF DE FIXATION DE CARTE D'INTERFACE ET MODULE DE CARTE PRINCIPAL

(30) Priority: 06.10.2016 TW 105132312
(43) Date of publication of application: 11.04.2018
(73) Proprietor: Giga-Byte Technology Co., Ltd., New Taipei City 231 (TW)
(72) Inventor: LAI, Chih-Ming, 231 New Taipei City (TW); KAO, Yung-Shun, 231 New Taipei City (TW); CHIANG, Chung-Wei, 231 New Taipei City (TW)
(74) Representative: Argyma

(56) References cited:
- US-A- 2 542 144
- US-A- 6 112 911
- US-A1- 2003 001 467
- US-A1- 2008 227 326
- US-B1- 7 335 032

## Description

### BACKGROUND OF THE INVENTION

### 1. Field of the Invention

The invention relates to a fixing device and a main board module, and more particularly, to an interface card fixing device and a main board module.

### 2. Description of Related Art

With increasing demands from users, main boards are provided with a variety of connectors for providing more functionality. Currently, many main boards are disposed with a NGFF (Next Generation Form Factor) slot (i.e., M.2 slot) for inserting an M.2 interface card (e.g., a solid state hard drive (SSD) with M.2 interface). In addition to the M.2 slot, these main boards must also be disposed with a via hole for fixing the M.2 interface card at a corresponding position beside the M.2 slot, such that after one end of the M.2 interface card is inserted into the M.2 slot on the main board, the other end may be fixed to the main board through locking or other methods to increase the stability of the M.2 interface card.

In terms of locking with screw, because the M.2 interface card is provided with a semicircular hole for positioning on an edge of another end relative to an electrical connecting end, a threaded portion of the screw will be located within the semicircular hole, and a top portion of the screw will press against a portion of the M.2 interface card close to the semicircular hole, so as to fix a relative position of the M.2 interface card to the main board. However, since there is only one half of the top portion of the screw pressing against the portion of the M.2 interface card close to the semicircular hole while the other half of the top potion of the screw is hanging, skew phenomenon are likely to occur on one side when locking with screw is over tighten. Consequently, an uneven force may be applied from screw to the portion of the M.2 interface card close to the semicircular hole. In addition, locking with screw also requires additional tools for assembling and disassembling the M.2 interface card, and is thus less convenient in use. Another prior art solution, disclosed in application US 2008/0227326, presents the problem of having a high space utilization.

### SUMMARY OF THE INVENTION

The invention provides an interface card fixing device, and a main board module, which includes the above interface card fixing device as further defined in the appended claims.

An interface card fixing device of the invention is adapted to fix an interface card to a main board. The interface card fixing device includes a base, a fixing portion, an engaging portion and a connecting portion. The base includes a first surface, a second surface opposite to the first surface, and a protrusion protruding from the first surface, and the base has a through hole passing through the first surface, the second surface and the protrusion so that the protrusion forms a hollow cylinder. The fixing portion extends from the second surface of the base and includes a breach communicating with the through hole. The engaging portion is adapted to pass through the through hole and the breach, and fix to the base. The connecting portion is connected to the base and the engaging portion.

In an embodiment of the invention, the interface card fixing device further includes a handle portion, connected to the engaging portion. An included angle between an extending direction of the handle portion relative to the engaging portion and an extending direction of the connecting portion relative to the engaging portion is a right angle, an obtuse angle or an acute angle.

In an embodiment of the invention, the handle portion has a rough surface or a convex mark.

In an embodiment of the invention, the engaging portion includes a pressing unit and a plug protruding from the pressing unit. The pressing unit is adapted to press against the interface card. The plug is adapted to enter the breach of the fixing portion. A size of one end of the plug close to the pressing unit is greater than a size of one end of the plug away from the pressing unit.

In an embodiment of the invention, the plug includes a first end and a second end opposite to each other. The second end is away from the pressing unit and adapted to pass through the through hole, enter and expand the breach. The first end is close to the pressing unit and adapted to engage with the through hole and fix to the base. In an embodiment of the invention, a size of the breach of the fixing portion is less than a size of the through hole.

A main board module of the invention is adapted to install an interface card. The interface card includes a connecting end and a fixing end. An edge of the fixing portion has a semicircular hole. The main board module includes a main board and an interface card fixing device. The main board includes an interface card slot and a via hole, wherein the connecting end of the interface card is adapted to be inserted into the interface card slot. The interface card fixing device is adapted to fix the fixing end of the interface card to the main board. The interface card fixing device includes a base, a fixing portion, an engaging portion and a connecting portion. The base includes a first surface, a second surface opposite to the first surface, and a protrusion protruding from the first surface, and the base has a through hole passing through the first surface, the second surface and the protrusion so that the protrusion forms a hollow cylinder. The fixing portion is detachably disposed passing through the via hole of the main board. The fixing portion extends from the second surface of the base and includes a breach communicating with the through hole. The engaging portion is adapted to pass through the through hole and the breach, and fix to the base. The connecting portion is connected to the base and the engaging portion. When the interface card is installed on the main board module, the connecting end is inserted into the interface card slot, the fixing portion leans against the first surface of the base so the protrusion is located within the semicircular hole, and the engaging portion engages with the base and presses against the interface card.

In an embodiment of the invention, the interface card fixing device further includes a handle portion, connected to the engaging portion. An included angle between an extending direction of the handle portion relative to the engaging portion and an extending direction of the connecting portion relative to the engaging portion is a right angle, an obtuse angle or an acute angle.

In an embodiment of the invention, the handle portion has a rough surface or a convex mark.

In an embodiment of the invention, the engaging portion includes a pressing unit and a plug protruding from the pressing unit. The pressing unit is adapted to press against the portion of the interface card beside the semicircular hole. The plug is adapted to enter the breach of the fixing portion. A size of one end of the plug close to the pressing unit is greater than a size of one end of the plug away from the pressing unit.

In an embodiment of the invention, a size of the breach of the fixing portion is less than a size of the through hole.

Based on the above, the interface card fixing device of the invention can be detachably disposed through the main board by the fixing portion. When the interface card is installed on the main board module, the connecting portion of the interface card is inserted into the interface card slot, the fixing portion of the interface card leans against the first surface of the interface card fixing device, and the protrusion of the base is located within the semicircular hole of the interface card. At this time, the semicircular hole of the interface card is aligned with the through hole of the base of the interface card fixing device and the breach of the fixing portion. The plug of the interface card fixing device can enter the semicircular hole of the interface card, the through hole of the base and the breach of the fixing portion and fix to the base. Also, the pressing unit of the engaging portion will press against the portion of the interface card beside the semicircular hole to fix the fixing portion of the interface card to the main board. In this way, the installation can be quite simple and convenient without the need for additional tools. Further, because the engaging portion of the interface card fixing device and the base are fixed at their engagement position, when the plug of the engaging portion is fixed to the base, the pressing unit can provide a constant and even clamping force to the portion of the interface beside the semicircular hole. As such, the conventional situation in which skew phenomenon occurs due to over tighten locking when fixing the interface card to the main board by locking with screw may be effectively solved. In addition, with the design of the protrusion in from of the hollow cylinder for the interface card fixing device of the invention, the user can freely rotate the interface card fixing device at the position relative to the main board (with the rotatable angle within almost 180 degrees), and the protrusion will be located within the semicircular hole of the interface card as along as the connecting portion has no interference with the parts on the interface card or the main board. As a result, the user can arrange the position of the connection portion on the main board depending on actual conditions, so as to prevent interference from happening.

To make the above features of the disclosure more comprehensible, several embodiments accompanied with drawings are described in detail as follows.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a 3D view illustrating an interface card installed on a main board module before an interface card fixing device presses against the interface card according to an embodiment of the invention.
FIG. 2 to FIG. 4 are schematic views of the interface card fixing device of FIG. 1 in different viewing angles.
FIG. 5 and FIG. 6 are local cross-sectional views of the interface card fixing device of FIG. 1, respectively, before and after pressing against the interface card.
FIG. 7 is a 3D view of the interface card fixing device of FIG. 1 pressing against the interface card.
FIG. 8 is a 3D view of the interface card fixing device of FIG. 1 turned into the other angle relative to the interface card.
FIG. 9 is a 3D view of the interface card fixing device of FIG. 1 pressing against the interface card in the other angle.

### DESCRIPTION OF THE EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

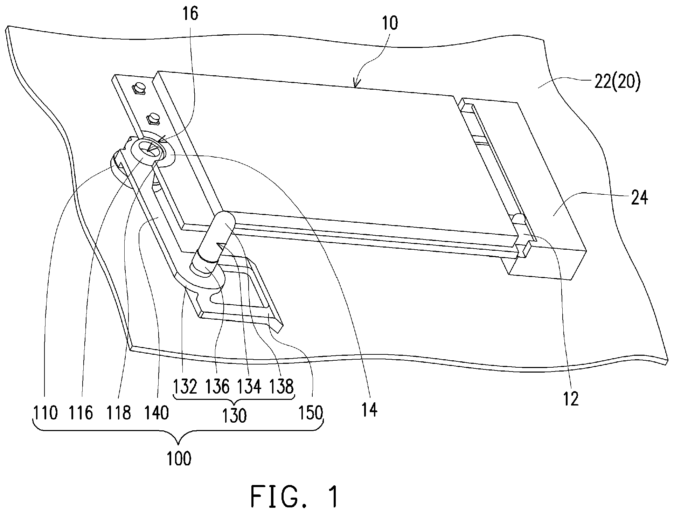

FIG. 1 is a 3D view illustrating an interface card installed on a main board module before an interface card fixing device presses against the interface card according to an embodiment of the invention. With reference to FIG. 1, a main board module 20 of the present embodiment includes a main board 22 and an interface card fixing device 100. The main board 22 includes an interface card slot 24 and a via hole 26 corresponding to the interface card slot 24. An interface card 10 may be inserted into the interface card slot 24 and fixed onto the via hole 26 of the main board 22 by the interface card fixing device 100.

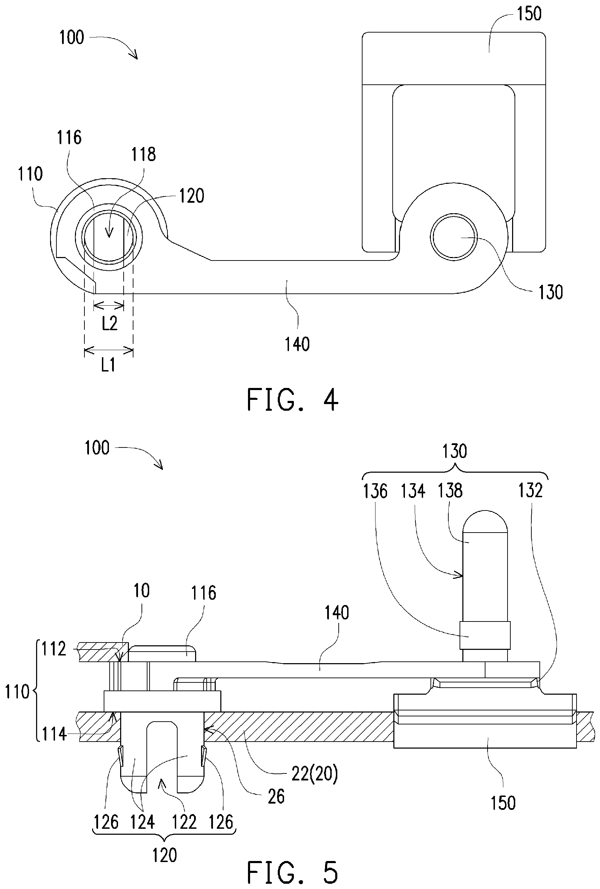

In the present embodiment, the interface card slot 24 is an NGFF (Next Generation Form Factor) interface card slot 24 (i.e., the interface card slot 24 with an M.2 interface), for example, but the type of the interface card slot 24 is not limited thereto. In general, a plurality of the via holes 26 are provided on the main board 22 (only one of the via holes 26 is schematically illustrated in FIG. 5) at nearby places which are 42mm, 60mm, 80mm and 110mm, respectively, away from the interface card slot 24 with the M.2 interface. As such, in correspondence to a length of the M.2 interface card selected by the user, the M.2 interface card of the corresponding length can be fixed to the through hole 26.

Similarly, in the present embodiment, the interface card 10 is an NGFF (Next Generation Form Factor) interface card, for example, but the type of the interface card 10 is not limited thereto. The interface card 10 includes a connecting end 12 and a fixing connection 14, where an edge of the fixing end 14 has a semicircular hole 16. When the interface card 10 is installed on the main board module 20, the connecting end 12 of the interface card 10 is inserted into the interface card slot 24, and the fixing end 14 of the interface card 10 can be fixed to the via hole 26 of the main board 22 through the interface card fixing device 100 quickly, easily and stably. Description regarding the above is provided in detail below.

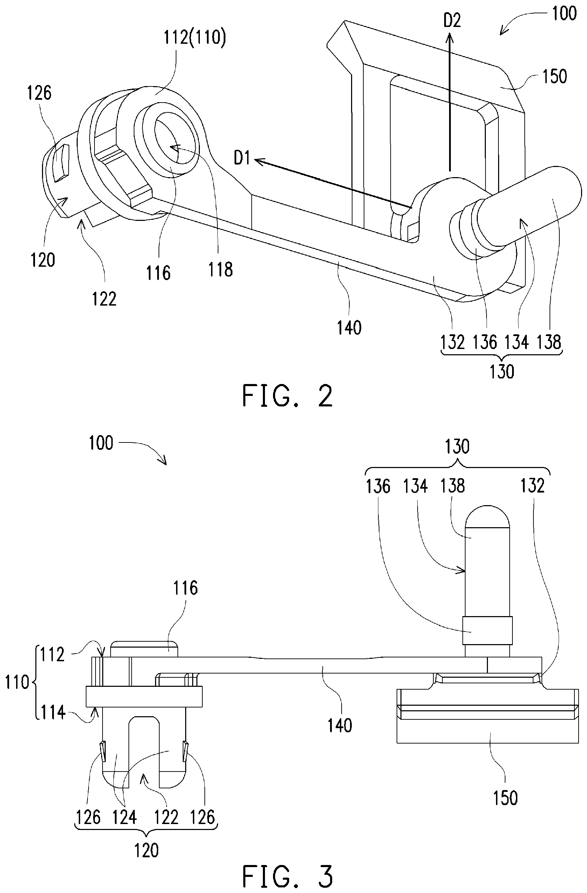

FIG. 2 to FIG. 4 are schematic views of the interface card fixing device of FIG. 1 in different viewing angles. With reference to FIG. 2 to FIG. 4, the interface card fixing device 100 includes a base 110, a fixing portion 120, an engaging portion 130, a connecting portion 140 and a handle portion 150. The base 110 includes a first surface 112 and a second surface 114 opposite to each other and a protrusion 116 protruding from the first surface 112, and the base 110 has a through hole 118 passing through the first surface 112, the second surface 114 and the protrusion 116 so that the protrusion 116 forms a hollow cylinder.

The fixing portion 120 extends from the second surface 114 of the base 110 and includes a breach 122 communicating with the through hole 118. More specifically, the fixing portion 120 includes two extending sections 124 (marked in FIG. 3) spaced apart by the breach 122, and the two extending sections 124 include engaging bumps 126 outwardly protruding at positions away form each other.

The engaging portion 130 includes a pressing unit 132 and a plug 134 protruding from the pressing unit 132. The plug 134 includes a first end 136 and a second end 138 opposite to each other. The first end 136 of the plug 134 is close to the pressing unit 132, and the second end 138 of the plug 134 is away from the pressing unit 132. The connecting portion 140 is connected to the base 110 and the engaging portion 130, and the handle portion 150 is connected to the engaging portion 130.

In the present embodiment, a size of the first end 136 of the plug 134 is greater than or equal to a size of the through hole 118 of the base 110, and the size of the through hole 118 of the base 110 is greater than a size of the second end 138 of the plug 134. In other words, the plug 134 has the size of the first end 136 being greater than the size of the second end 138. In addition, as shown in FIG. 4, in the present embodiment, a size L2 of the breach 122 of the fixing portion 120 (i.e., a distance between the two extending portions 124) is less than an inner diameter L1 of the through hole 118. Also, in view of FIG. 3, it can be known that an outer diameter of the second end 138 of the plug 134 is greater than the size L2 of the breach 122 of the fixing portion 120. With the size relationship above, in the present embodiment, the second end 138 of the plug 134 of the engaging portion 130 is adapted to pass through the through hole 118, enter and expand the breach 122, and the first end 136 of the plug 134 can engage with a wall surface beside the through hole 118 of the base 110 and fix to the base 110.

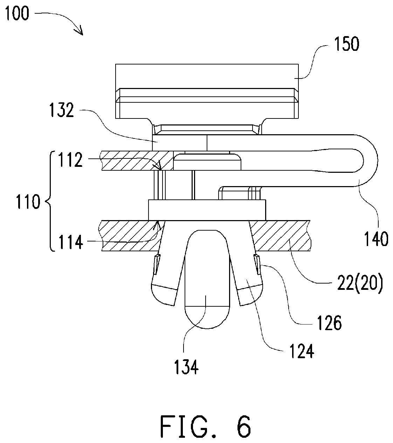

FIG. 5 and FIG. 6 are local cross-sectional views of the interface card fixing device of FIG. 1, respectively, before and after pressing against the interface card. With reference to FIG. 5, the fixing portion 120 is detachably disposed through the via hole 26 of the main board 22. More specifically, when the interface card fixing device 100 is disposed in a top-down manner on the main board 22 as shown in FIG. 5, a portion of the fixing portion 120 is located within the via hole 26 of the main board 22, and another portion (i.e., a portion that is away from the base 110) of the fixing portion 120 passes through the via hole 26 to be located on another side of the main board 22 (i.e., below the main board 22 of FIG. 5). As shown in FIG. 5, in the present embodiment, because the two engaging bumps 126 on the two extending sections 124 of the fixing portion 120 are located below the main board 22, a distance between the two engaging bumps 126 will be greater than a size of the via hole 26 of the main board 22 so the fixing portion 120 cannot be easily moved up and detached from the main board 22.

Referring to FIG. 1 and FIG. 5 together, when the interface card 10 is installed on the main board module 20, the connecting end 12 of the interface card 10 is inserted into the interface card slot 24, the fixing end 14 of the interface card 10 leans against the first surface 112 of the base 110 and the protrusion 116 is located within the semicircular hole 16 of the interface card 10. When the interface card fixing device 100 is to be used to fix the interface card 10 to the main board 22, with reference to FIG. 6, the second end 138 of the plug 134 of the engaging portion 130 of the interface card fixing device 100 sequentially passes through the semicircular hole 16 of the interface card 10 and the through hole 118 of the base 110, enters the breach 122 of the fixing portion 120 and expands the breach 122 of the fixing portion 120. At this time, the two extending sections 124 of the fixing portion 120 are pushed open by the plug 134 to two sides. As can be clearly seen from FIG. 6, when the plug 134 is inserted into the breach 122 of the fixing portion 120, the two engaging bumps 126 on the two extending sections 124 are farther away from each other so the distance between the two engaging bumps 126 is even greater than the size of the via hole 26 of the main board 22. Accordingly, the fixing portion 120 can be fixed to the main board 22 more stably.

Moreover, in the present embodiment, it is given that the size of the first end 136 of the plug 134 is greater than or equal to the size of the through hole 118 of the base 110, and the size of the through hole 118 of the base 110 is greater than the size of the second end 138 of the plug 134. During the process of fixing the plug 134 of the engaging portion 130 to the base 110, the second end 138 of the plug 134 can easily pass through the through hole 118 of the base 110, and the first end 136 of the plug 134 will tightly engage with the wall surface beside the through hole 118 when entering the through hole 118 of the base 110, and fix to the base 110.

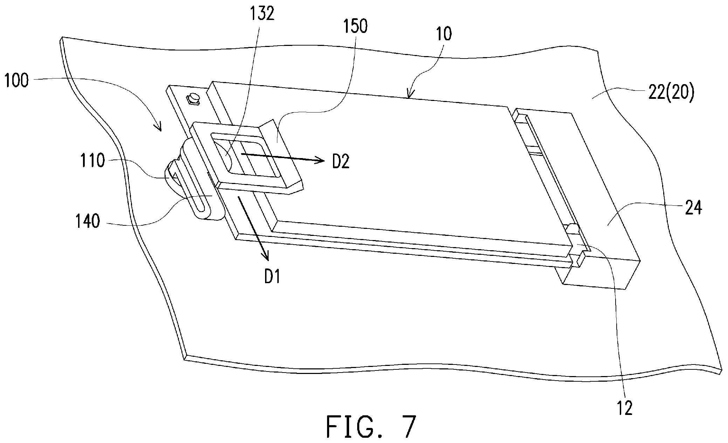

In addition, FIG. 7 is a 3D view of the interface card fixing device of FIG. 1 pressing against the interface card. Referring to FIG. 6 and FIG. 7 together, because the portion of the interface card 10 beside the semicircular hole 16 is located on the first surface 112 of the base 10 and surrounding one half of the protrusion 116, after the plug 134 of the engaging portion 130 is fixed to the base 110, the pressing unit 132 of the engaging portion 130 will press against the portion of the interface card 10 beside semicircular hole 16 to clamp the portion of the interface card 10 beside semicircular hole 16 in between the pressing unit 132 of the engaging portion 130 and the first surface 112 of the base 110, so as to fix the fixing end 14 of the interface card 10.

In other words, when intending to install the interface card 10 on the main board 22, the user only needs to insert the fixing portion 120 of the interface card fixing device 100 into the via hole 26 of the main board 22, insert the connecting end 12 of the interface card 10 into the interface card slot 24 of the main board 22, align the semicircular hole 16 on the fixing end 14 of the interface card 10 with the protrusion 116 of the base 110 of the interface card fixing device 100, and lastly, insert the plug 134 of the engaging portion 130 of the interface card fixing device 100 into the through hole 118 of the base 110 until the plug 134 engages with the base 110. Similarly, if the interface card 10 is to be detached from the main board 22, it is only required to apply force for pulling up the handle portion 150 so the plug 134 of the engaging portion 130 will then be detached from the base 110 to release engagement of the pressing unit 132 of the engaging portion 130 and the first surface 112 of the base 110 to the fixing portion 14 of the interface card 10.

As shown in FIG. 7, in the present embodiment, the handle portion 150 has a rough surface or a convex mark to increase the friction force, which facilitates the user to pull up the handle portion 150. After the interface card 10 is removed, the user can apply force again to pull out the fixing portion 120 from the via hole 26 of the main board 22 so the interface card fixing device 100 can be detached from the main board 22. In this way, the interface card fixing device 100 of the present embodiment is very easy and simple and can be assembled without the need for additional tools. Further, because the engaging portion 130 of the interface card fixing device 100 of the present embodiment and the base 110 are fixed at their engagement position, the conventional situation in which skew phenomenon occurs due to overly tight screw locking when fixing the interface card 10 to the main board 22 by locking with screw may be effectively solved.

It is noted that, the space on the main board 22 is limited. For instance, connectors or other parts located at an edge of the main board 22 may exist in an extending direction of the interface card slot 24 towards the via hole 26, and thus a distance from the via hole 26 to the connectors or other parts located at the edge of the main board 22 may be quite close. Accordingly, if an extending direction D1 of the connection portion 140 relative to the engaging portion 130 is parallel to an extending direction of the M.2 interface card slot 24 towards the via hole 26, the connecting portion 140 may have interference with the connectors at the edge of the main board 22. Furthermore, in order to facilitate holding for the user, the handle portion 150 is usually made with a certain size, and the size of the handle portion 150 may even be greater than the size of the connecting portion 140 so it is likely that the handle portion 150 may also have interference with the connectors or other parts at the edge of the main board 22.

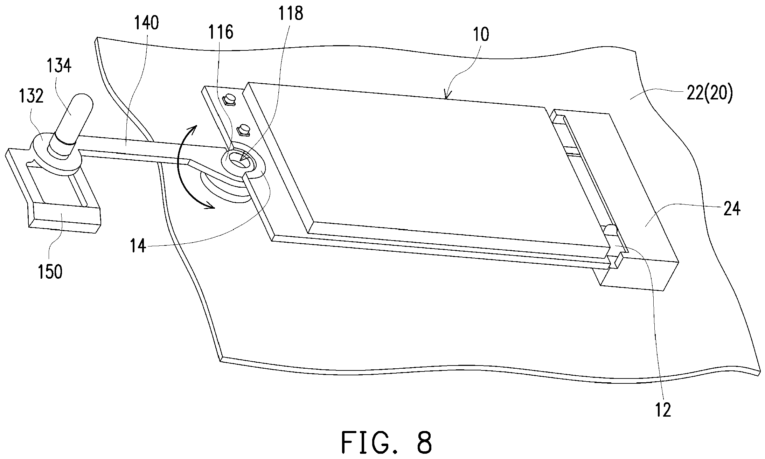

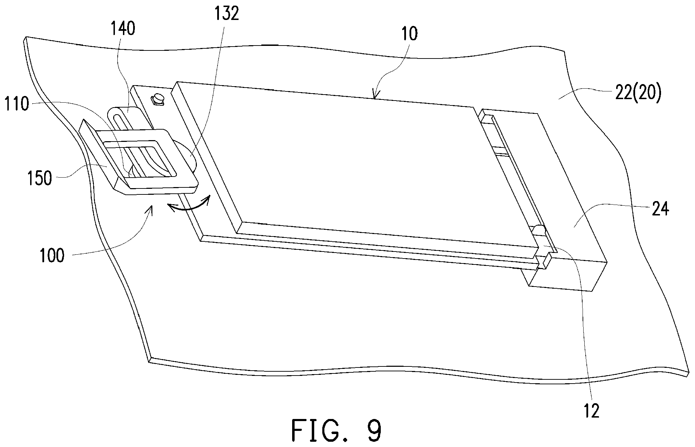

In order to reduce the probability for the above interference to occur, the protrusion 116 of the interface card fixing device 100 of the present embodiment is specifically designed in shape of the hollow cylinder. By doing so, the user can freely rotate the interface card fixing device 100 at a position relative to the main board 22 (with a rotatable angle within almost 180 degrees), and the protrusion 116 will be located within the semicircular hole 16 of the interface card 10 as long as the connection portion 140 has no interference with parts on the interface card 10 or the main board 22. FIG. 8 is a 3D view of the interface card fixing device of FIG. 1 turned into the other angle relative to the interface card. FIG. 9 is a 3D view of the interface card fixing device of FIG. 1 pressing against the interface card in the other angle. In view of FIG. 8 and FIG. 9, it can be clearly seen that, the connecting portion 140 of the interface card fixing device 100 of the present embodiment has the rotatable angle within almost 180 degrees, such that the user can easily choose to arrange the bent connecting portion 140 and the handle portion 150 to suitable positions on the main board 22 without having interference with the parts or the connectors on the main board 22. As shown in FIG. 9, in the present embodiment, in the case where the plug 134 of the engaging portion 130 is fixed to the base 110, the handle portion 150 may be moved to the suitable position within the rotation range depending on the user's needs. In a more preferable embodiment, the interface card fixing device 100 may be rotated within a range of 150 degrees after the interface card 10 is disposed on the main board 22. Certainly, the rotatable angle of the interface card fixing device 100 is not limited to the above.

In addition, as shown in FIG. 2 and FIG. 7, in the present embodiment, an included angle between an extending direction D2 of the handle portion 150 relative to the engaging portion 130 and the extending direction D1 of the connecting portion 140 relative to the engaging portion 130 may be a right angle, an obtuse angle or an acute angle. For instance, the extending direction D2 of the handle portion 150 relative to the engaging portion 130 is perpendicular to the extending direction D1 of the connecting portion 140 relative to the engaging portion 130, as shown in FIG. 7. Such configuration can have the handle portion 150 placed above the interface card 10 to avoid interference with other parts. Naturally, the angular relationship between the extending direction D2 of the handle portion 150 relative to the engaging portion 130 and the extending direction D1 of the connecting portion 140 relative to the engaging portion 130 is not limited to the above. In other embodiments, the included angle between the extending direction D2 of the handle portion 150 relative to the engaging portion 130 and the extending direction D1 of the connecting portion 140 relative to the engaging portion 130 may also be the acute angle or the obtuse angle.

In summary, the interface card fixing device of the invention can be detachably disposed through the main board by the fixing portion. When the interface card is installed on the main board module, the connecting portion of the interface card is inserted into the interface card slot, the fixing portion of the interface card leans against the first surface of the interface card fixing device, and the protrusion of the base is located within the semicircular hole of the interface card. At this time, the semicircular hole of the interface card is aligned with the through hole of the base of the interface card fixing device and the breach of the fixing portion. The plug of the interface card fixing device can enter the semicircular hole of the interface card, the through hole of the base and the breach of the fixing portion, and fix to the base. Also, the pressing unit of the engaging portion will press against the portion of the interface card beside the semicircular hole to fix the fixing portion of the interface card to the main board. In this way, the installation can be quite simple and convenient without the need for additional tools. Further, because the engaging portion of the interface card fixing device and the base are fixed at their engagement position, when the plug of the engaging portion is fixed to the base, the pressing unit can provide a constant and even clamping force to the portion of the interface beside the semicircular hole. As such, the conventional situation in which skew phenomenon occurs due to over tighten locking when fixing the interface card to the main board by locking with screw may be effectively solved. In addition, with the design of the protrusion in from of the hollow cylinder for the interface card fixing device of the invention, the user can freely rotate the interface card fixing device at the position relative to the main board (with the rotatable angle within almost 180 degrees), and the protrusion will be located within the semicircular hole of the interface card as along as the connecting portion has no interference with the parts on the interface card or the main board. As a result, the user can arrange the position of the connection portion on the main board depending on actual conditions, so as to prevent interference from happening.

## Claims

1. An interface card fixing device (100), adapted to fix an interface card (10) to a main board (22), the interface card fixing device (100) comprising:
a base (110), comprising a first surface (112), a second surface (114) opposite to the first surface (112), and a protrusion (116) protruding from the first surface (112), the base (110) having a through hole (118) passing through the first surface (112), the second surface (114) and the protrusion (116) so that the protrusion (116) forms a hollow cylinder;
a fixing portion (120), extending from the second surface (114) of the base (110), and comprising a breach (122) communicating with the through hole (118);
an engaging portion (130), adapted to pass through the through hole (118) and the breach (122), and fix to the base (110);
a connection portion (140), connected to the base (110) and the engaging portion (130), and
a handle portion (150), connected to the engaging portion (130), wherein an extending direction of the handle portion (150) extending from the engaging portion (130) is perpendicular to an extending direction of the connecting portion (140) extending from the engaging portion (120).

2. The interface card fixing device (100) as recited in claim 1, wherein the handle portion (150) has a rough surface or a convex mark.

3. The interface card fixing device (100) as recited in claim 1, wherein the engaging portion (130) comprises a pressing unit (132) and a plug (134) protruding from the pressing unit (132), the pressing unit (132) being adapted to press against the interface card (10), the plug (134) being adapted to enter the breach (122) of the fixing portion (120), a size of one end of the plug (134) close to the pressing unit (132) being greater than a size of one end of the plug (134) away from the pressing unit (132).

4. The interface card fixing device (100) as recited in claim 3, wherein the plug (134) comprises a first end (136) and a second end (138) opposite to each other, the second end (138) being away from the pressing unit (132) and adapted to pass through the through hole (118), enter and expand the breach (122), the first end (136) being close to the pressing unit (132) and adapted to engage with the through hole (118) and fix to the base (110).

5. The interface card fixing device (100) as recited in claim 1, wherein a size of the breach (122) of the fixing portion (120) is smaller than a size of the through hole (118).

6. A main board module (20), adapted to install an interface card (10), the interface card (10) comprising a connecting end (12) and a fixing end (14), an edge of the fixing end (14) having a semicircular hole (16), the main board module (20) comprising:
a main board (22), comprising an interface card slot (24) and a via hole (26), wherein the connecting end (12) of the interface card (10) is adapted to be inserted into the interface card slot (24); and
an interface card fixing device (100), as set forth in any of the preceding claims, wherein, when the interface card (10) is installed on the main board module (20), the connecting end (12) is inserted into the interface card slot (24), the fixing portion (14) leans against the first surface (112) of the base (110), the protrusion (116) is located within the semicircular hole (16), and the engaging portion (130) engages with the base (110) and presses against the interface card (10).

## Patentansprüche

1. Schnittstellenkartenbefestigungsvorrichtung (100), eingerichtet, um eine Schnittstellenkarte (10) an einem Mainboard (22) zu befestigen, wobei die Schnittstellenkartenbefestigungsvorrichtung (100) umfasst:
eine Basis (110), umfassend eine erste Oberfläche (112), eine zweite Oberfläche (114) gegenüberliegend der ersten Oberfläche (112), und einen Vorsprung (116), der von der ersten Oberfläche (112) hervorragt, wobei die Basis (110) ein Durchgangsloch (118) hat, das durch die erste Oberfläche (112), die zweite Oberfläche (114) und den Vorsprung (116) läuft, sodass der Vorsprung (116) einen Hohlzylinder bildet;
einen Befestigungsabschnitt (120), der sich von der zweiten Oberfläche (114) der Basis (110) erstreckt, und der eine Lücke (122) umfasst, die mit dem Durchgangsloch (118) kommuniziert;
einen Eingriffsabschnitt (130), eingerichtet, um durch das Durchgangsloch (118) und die Lücke (122) zu laufen, und an der Basis (110) zu befestigen;
einen Verbindungsabschnitt (140), verbunden mit der Basis (110) und dem Eingriffsabschnitt (130), und
einem Griffabschnitt (150), verbunden mit dem Eingriffsabschnitt (130), wobei eine Auszugsrichtung des Griffabschnitts (150), die sich von dem Eingriffsabschnitt (130) erstreckt, senkrecht zu einer Auszugsrichtung des Verbindungsabschnitts (140) ist, der sich von dem Eingriffsabschnitt (120) erstreckt.

2. Schnittstellenkartenbefestigungsvorrichtung (100) nach Anspruch 1, wobei der Griffabschnitt (150) eine raue Oberfläche oder eine konvexe Markierung hat.

3. Schnittstellenkartenbefestigungsvorrichtung (100) nach Anspruch 1, wobei der Eingriffsabschnitt (130) eine Presseinheit (132) und einen Stopfen (134) umfasst, der von der Presseinheit (132) hervorragt, wobei die Presseinheit (132) eingerichtet ist, um gegen die Schnittstellenkarte (10) zu pressen, wobei der Stopfen (134) eingerichtet ist, um in die Lücke (122) des Befestigungsabschnitts (120) einzutreten, wobei eine Größe eines Endes des Stopfens (134) nahe der Presseinheit (132) größer als eine Größe eines Endes des Stopfens (134) weg von der Presseinheit (132) ist.

4. Schnittstellenkartenbefestigungsvorrichtung (100) nach Anspruch 3, wobei der Stopfen (134) ein erstes Ende (136) und ein zweites Ende (138) einander gegenüberliegend umfasst, wobei das zweite Ende (138) weg von der Presseinheit (132) ist und eingerichtet, um durch das Durchgangsloch (118) zu laufen, in die Lücke (122) einzutreten und sie zu erweitern, wobei das erste Ende (136) nahe der Presseinheit (132) ist und eingerichtet, um mit dem Durchgangsloch (118) in Eingriff zu kommen und an der Basis (110) zu befestigen.

5. Schnittstellenkartenbefestigungsvorrichtung (100) nach Anspruch 1, wobei eine Größe der Lücke (122) des Befestigungsabschnitts (120) kleiner als eine Größe des Durchgangslochs (118) ist.

6. Mainboardmodul (20), eingerichtet, um eine Schnittstellenkarte (10) zu installieren, wobei die Schnittstellenkarte (10) ein Verbindungsende (12) und ein Befestigungsende (14) umfasst, wobei eine Kante des Befestigungsendes (14) ein halbkreisförmiges Loch (16) hat, wobei das Mainboardmodul (20) umfasst:
ein Mainboard (22), umfassend einen Schnittstellenkartenslot (24) und ein Durchkontaktierungsloch (26), wobei das Verbindungsende (12) der Schnittstellenkarte (10) eingerichtet ist, um in den Schnittstellenkartenslot (24) eingesetzt zu werden; und
eine Schnittstellenkartenbefestigungsvorrichtung (100) nach einem der vorstehenden Ansprüche, wobei, wenn die Schnittstellenkarte (10) auf dem Mainboardmodul (20) installiert ist, das Verbindungsende (12) in den Schnittstellenkartenslot (24) eingesetzt ist, wobei der Befestigungsabschnitt (14) gegen die erste Oberfläche (112) der Basis (110) lehnt, wobei der Vorsprung (116) innerhalb des halbkreisförmigen Lochs (16) angeordnet ist, und wobei der Eingriffsabschnitt (130) mit der Basis (110) in Eingriff ist und gegen die Schnittstellenkarte (10) presst.

## Revendications

1. Dispositif de fixation de carte d'interface (100), adapté pour fixer une carte d'interface (10) à un une carte principale (22), le dispositif de fixation de carte d'interface (100) comprenant :
une base (110), comprenant une première surface (112), une seconde surface (114) opposée à la première surface (112), et une partie saillante (116) faisant saillie à partir de la première surface (112), la base (110) ayant un trou traversant (118) traversant la première surface (112), la seconde surface (114) et la partie saillante (116) de sorte que la partie saillante (116) forme un cylindre creux ;
une partie de fixation (120), s'étendant à partir de la seconde surface (114) de la base (110), et comprenant une percée (122) communiquant avec le trou traversant (118);
une partie de solidarisation (130), adaptée pour traverser le trou traversant (118) et la percée (122), et se fixer à la base (110) ;
une partie de connexion (140), connectée à la base (110) et à la partie de solidarisation (130), et
une partie de préhension (150), connectée à la partie de solidarisation (130), dans laquelle une direction d'extension de la partie de préhension (150) s'étendant à partir de la partie de solidarisation (130) est perpendiculaire à une direction d'extension de la partie de connexion (140) s'étendant à partir de la partie de solidarisation (120).

2. Dispositif de fixation de carte d'interface (100) selon la revendication 1, dans lequel la partie de préhension (150) présente une surface rugueuse ou une marque convexe.

3. Dispositif de fixation de carte d'interface (100) selon la revendication 1, dans lequel la partie de solidarisation (130) comprend une unité de pression (132) et une prise (134) faisant saillie à partir de l'unité de pression (132), l'unité de pression (132) étant adaptée pour se presser contre la carte d'interface (10), la prise (134) étant adaptée pour entrer dans la percée (122) de la partie de fixation (120), une taille d'une extrémité de la prise (134) proche de l'unité de pression (132) étant supérieure à une taille d'une extrémité de la prise (134) éloignée de l'unité de pression (132).

4. Dispositif de fixation de carte d'interface (100) selon la revendication 3, dans lequel la prise (134) comprend une première extrémité (136) et une seconde extrémité (138) opposées l'une à l'autre, la seconde extrémité (138) étant éloignée de l'unité de pression (132) et adaptée pour traverser le trou traversant (118), entrer dans la percée (122) et l'étendre, la première extrémité (136) étant proche de l'unité de pression (132) et adaptée pour se solidariser avec le trou traversant (118) et se fixer à la base (110).

5. Dispositif de fixation de carte d'interface (100) selon la revendication 1, dans lequel une taille de la percée (122) de la partie de fixation (120) est plus petite qu'une taille du trou traversant (118).

6. Module de carte principale (20), adapté pour installer une carte d'interface (10), la carte d'interface (10) comprenant une extrémité de connexion (12) et une extrémité de fixation (14), un bord de l'extrémité de fixation (14) ayant un trou semi-circulaire (16), le module de carte principale (20) comprenant :
une carte principale (22), comprenant une fente de carte d'interface (24) et un trou d'interconnexion (26), dans lequel l'extrémité de connexion (12) de la carte d'interface (10) est adaptée pour être insérée dans la fente de carte d'interface (24) ; et
un dispositif de fixation de carte d'interface (100), selon l'une quelconque des revendications précédentes, dans lequel lorsque la carte d'interface (10) est installée sur le module de carte principale (20), l'extrémité de connexion (12) est insérée dans la fente de carte d'interface (24), la partie de fixation (14) s'appuie contre la première surface (112) de la base (110), la partie saillante (116) est située à l'intérieur du trou semi-circulaire (16), et la partie de solidarisation (130) se solidarise avec la base (110) et exerce une pression contre la carte d'interface (10).
